Europäisches Patentamt

European Patent Office

Office européen des brevets

(11) Numéro de publication: **0 117 778**
**B1**

(12) **FASCICULE DE BREVET EUROPEEN**

(45) Date de publication du fascicule du brevet: **02.09.87**

(21) Numéro de dépôt: **84400152.9**

(22) Date de dépôt: **24.01.84**

(51) Int. Cl.⁴: **H 01 P 1/26,** H 01 C 10/02, G 01 R 1/20

(54) **Charge hyperfréquence à liquide conducteur, pour générateur de grande puissance.**

(30) Priorité: **31.01.83 FR 8301455**

(43) Date de publication de la demande:
**05.09.84 Bulletin 84/36**

(45) Mention de la délivrance du brevet:
**02.09.87 Bulletin 87/36**

(84) Etats contractants désignés:
**CH DE GB LI**

(56) Documents cités:
**US-A-3 350 671**

**REVIEW OF SCIENTIFIC INSTRUMENTS, vol. 42, no. 4, avril 1971, pages 544-545, New York, US; F.E.VERMEULEN et al: "A simple, inexpensive high power low frequency water load"**

(73) Titulaire: **THOMSON-CSF**
**173, Boulevard Haussmann**
**F-75379 Paris Cedex 08 (FR)**

(72) Inventeur: **Ursenbach, François**
**THOMSON-CSF SCPI 173, bld Haussmann**
**F-75379 Paris Cedex 08 (FR)**

(74) Mandataire: **Courtellemont, Alain et al**
**THOMSON-CSF SCPI 19, avenue de Messine**
**F-75008 Paris (FR)**

Courier Press, Leamington Spa, England.

**Description**

La présente invention se rapporte aux charges hyperfréquences utilisées pour tester les générateurs de grande puissance et plus particulièrement aux charges à liquide conducteur.

Il est connu d'utiliser des charges à liquide conducteur pour faire des mesures avec des générateurs hyperfréquences de grande puissance. Dans ces charges le liquide conducteur circule dans un circuit hydraulique grâce à un pompe associée à des moyens de refroidissement, et sert d'une part d'impédance de charge quand il passe dans une portion du circuit hydraulique formée de tuyaux isolants et d'autre part de moyen d'évacuation des calories produits dans la portion du circuit où il sert d'impédance de charge. Or la conductivité des liquides conducteurs employés dans ces charges varie très fortement avec la température; c'est ainsi que, avec le bicarbonate de soude dissous dans l'eau qui est un liquide conducteur couramment employé, la conductivité double lorsque la température augmente de 40°C. Il s'en suit que l'impédance des charges hyperfréquences connues, utilisant des liquides conducteurs, varie au fur et à mesure que la température varie; comme rien ne permet de compenser ces variations il faut attendre qu'un état d'équilibre des températures soit établi pour faire des mesures. De plus, si les mesures doivent être effectuées pour différentes températures du liquide conducteur correspondant à différentes puissances de sortie du générateur, il faut, soit prévoir des moyens de refroidissement suffisants pour rendre aussi faible que possible l'écart entre ces différentes températures, soit changer de charge lorsque les conditions d'expérimentation sont modifiées. Ce sont là des solutions onéreuses, souvent peu commodes et nécessitant du temps pour leur mise en oeuvre: attente de la température d'équilibre, temps nécessaire au remplacement d'une charge par une autre.

Par la présente invention il est possible de réduire les inconvénients précités grâce, en particulier, à un dispositif permettant de régler l'impédance de la charge hyperfréquence pour la maintenir ou l'amener à la valeur désirée.

Selon l'invention une charge hyperfréquence à liquide conducteur, pour générateur de grande puissance, comportant une première et une seconde pièce métallique conductrice, isolées électriquement l'une de l'autre et formant entre elles l'accès de la charge, et un circuit hydraulique formé de tuyaux en communication entre eux et contenant un liquide conducteurs, ces tuyaux comportant: des tuyaux conducteurs qui, pour une premiére et une deuxième partie, sont en contact respectivement avec la première et la second pièce, et des tuyaux isolants situés en série entre les tuyaux de la première et de la deuxième partie, est principalement caractérisée par un dispositif isolant placé à l'intérieur du circuit hydraulique et part des moyens pour introduire, .sur une longueur réglable, le dispositif isolant dans les tuyaux isolants.

La présente invention sera mieux comprise et d'autres caractéristiques apparaîtront à l'aide de la description ci-après et des figures s'y rapportant qui représentent:

la figure 1, une charge hyperfréquence selon l'art connu,

—les figures 2 et 3, deux exemples de réalisation de charges selon l'invention,

—les figures 4 et 5 deux vues d'une autre charge selon l'invention.

Sur les différentes figures les éléments correspondants sont désignés par les mêmes repères et les différentes pièces cachées par d'autres sont dessinées comme si elles étaient vues par transparence.

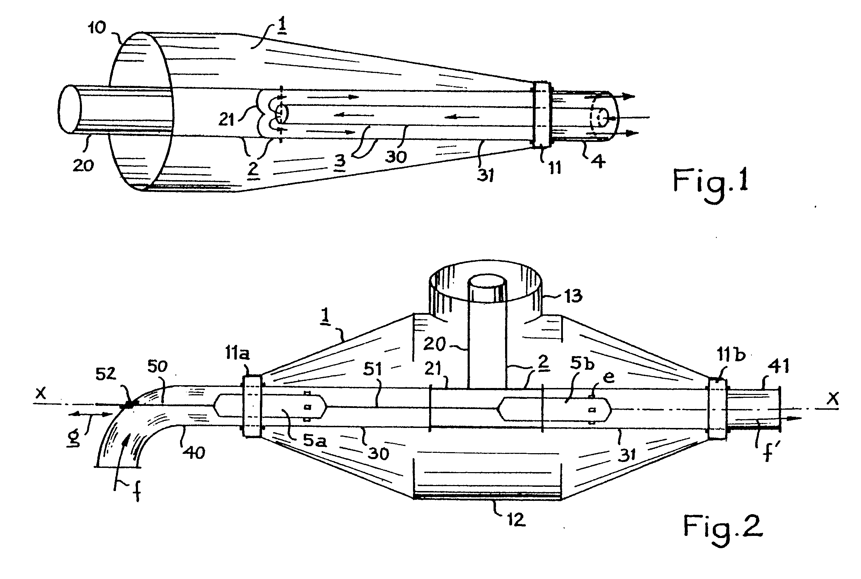

La figure 1 montre une charge hyperfréquence de type connu, à circulation de liquide conducteur. Cette charge se présente sensiblement sous la forme d'un entonnoir, traversé longitudinalement par un tube double. Elle comporte une enveloppe sensiblement conique, 10, en aluminium, constituant l'entonnoir; à l'ouverture la plus étroite de l'enveloppe 10 est situé un tuyau court ou bague, 11, en bronze, soudé à l'enveloppe. Un tuyau isolant 30, en stratifié de fibres de verre et de résine, traverse le trou de la bague 11 au centre de cette bague, pour pénérer dans l'enveloppe sur une longueur égale environ aux deux tiers de la longueur hors-tout de l'entonnoir. Le tuyau 30 est entouré, sur toute sa partie située à l'intérieur de l'enveloppe 10, par un autre tuyau isolant, 31, fixé à la bague 11 et dont la paroi interne est dans le prolongement de la paroi interne de la bague; de même, sur sa partie située à l'extérieur de l'enveloppe 10, le tuyau 30 est entouré d'un cylindre en cuivre, 4, dont la paroi interne est dans le prolongement de la paroi interne de la bague 11.

L'extrémité du tuyau isolant 31, opposé à la bague 11, est recouverte d'un tuyau coudé, 21, conducteur de l'électricité et formant un capuchon qui obstrue complètement l'ouverture du tuyau 31. Le tuyau 21 est fabriqué en cuivre; il est rendu solidaire, par soudure sur sa face opposée au tuyau 31, d'un tube métallique creux 20, qui ressort de l'enveloppe conique 10 par le milieu de l'ouverture la plus large de cette enveloppe.

La charge selon la figure 1 comporte un accés coaxial, qui se trouve constitué par l'enveloppe 10 à l'endroit de son ouverture la plus large et par le tube 20. Dans cette charge circule un liquide conducteur formé de bicarbonate de soude dissous dans l'eau; sous l'action d'une pompe, non représentée, associée à des moyens de refroidissement, également non représentés, le liquide conducteur pénètre par le tuyau isolant 30, arrive dans le tuyau métallique coudé 21, et repart par l'espace compris entre le tuyau 30 et, successivement le tuyau isolant 31, la bague métallique 11 et le cylindre 4; des flèches indiquent, sur la figure 1, le trajet suivi par le liquide à travers la charge. Dans le circuit hydraulique ainsi constitué, le liquide sert d'une part à l'évacuation des calories et d'autre part à constituer un élément résistif par le volume de liquide contenu dans le tuyau 31 (que ce soit entre les tuyaux 30 et 31 que à l'intérieur de la partie du tuyau 30 comprise dans le tuyau 31).

La charge qui vient d'être décrite à l'aide de la figure 1 présente les inconvénients mentionnés plus avant au sujet des charges hyperfréquences connues. L'invention propose de compenser les baisses de résistances du liquide conducteur, dues à l'élévation de température, par une réduction réglable de la quantité de liquide qui forme le cylindre résistif (contenu dans le tuyau 31 de la figure 1) et ceci en introduisant plus ou moins un dispositif isolant dans le cylindre résistif afin de diminuer la quantité de liquide qu'il comporte et, donc, d'augmenter sa résistance. Mais, avec une charge telle que celle selon la figure 1, l'introduction d'un dispositif isolant dans le cylindre résistif 31 pose, à l'usage, des problèmes de place pour loger le dispositif isolant; c'est pourquoi diverses formes de charges ont été étudiées pour faciliter cette introduction.

La figure 2 représente une charge selon l'invention dont les éléments internes sont vus par transparence. Cette charge comporte une enveloppe métallique 1 avec une partie cylindrique, 12, d'axe XX terminée à ses deux extrémités par des troncs de cône. L'enveloppe 1 comporte également un cylindre 13, d'axe, non représenté, perpendiculaire, à l'axe XX; ce cylindre 13 est extérieur à la partie cylindrique 12, à laquelle il est soudé à l'une de ses extémités; la partie cylindrique 12 est percée d'un trou dont le contour est dans le prolongement des parois internes du cylindre 13.

La figure 2 montre également que l'enveloppe 1 est traversée de part en part, selon l'axe XX, par un tube formé successivement d'un tuyau en cuivre 40 dans lequel un liquide conducteur arrive (flèche f) par une entrée latérale, d'un tuyau métallique court, formant une bague, 11a, soudée à l'enveloppe 1, d'un tuyau isolant 30, d'un tube métallique 21 placé sensiblement à l'aplomb du cylindre 13, d'un tuyau isolant 31 identique au tuyau 30, d'une bague 11b identique à la bague 11a et également soudée à l'enveloppe 1, et d'un tuyau en cuivre 41 servant à évacuer le liquide conducteur (flèche f').

Pour sa réalisation pratique, il est à noter que l'enveloppe métallique 1 est constituée de deux "demi-enveloppes" assemblées par vis: l'une sur laquelle sont soudées les bagues 11a et 11b et l'autre qui comporte le cylindre 13.

Sur la figure 2, apparaît un tube 20, réalisé en cuivre. Le tube 20 est situé à l'intérieur du cylindre 13, et est concentrique avec le cylindre 13; le tube 20 se prolonge jusqu'au tube métallique 21 à la paroi duquel il est soudé. L'accès de la charge selon la figure 2 est un accès coaxial dont les conducteurs sont constitués par les éléments 20 et 13.

Le tube que forment les pièces 40, 11a, 30, 21, 31, 11b, 41 de la figure 2, est un tube continu dont les éléments sont assemblés par brides. Ce tube présente une partie droite, d'axe XX, et est coudé à l'une de ses extrémités (tuyau coudé 40); un ensemble "pompe aspirante et refoulante- -moyens de refoidissement", non représenté, fait circuler dans ce tube un liquide conducteur qui pénètre par le tuyau 40 (flèche f) et resort par le tuyau 41 (flèche f').

La forme de cylindre large et continu, à section constante, que présente le tube dans lequel circule le liquide conducteur, permet d'y faire déplacer deux noyaux isolants 5a, 5b, en polytétrafluoroéthylène. Ces noyaux sont reliés entre eux par une barre de liaison 51 tandis qu'une autre barre, 50, relie le noyau 5a à un dispositif mécanique de réglage non représenté, car ne présentant par d'intérêt pour la compréhension de l'invention et ne faisant pas partie de la charge hyperfréquence proprement dite; la barre 50 traverse le tuyau 40, dans sa partie coudée, par un joint d'étanchéite 52.

Les noyaux 5a, 5b de la figure 2, forment avec les barres 50, 51 un ensemble rigide qui, par le dispositif de réglage mentionné ci-avant, peut être déplacé en translation (double flèche g) suivant l'axe XX. Trois ergots isolants, tels que e, disposés sur chacun des deux noyaux, à 120° les uns des autres autour de l'axe XX, sont en contact avec la paroi interne du tube où circule le liquide conducteur; ces ergots contribuent à ce que les noyaux isolants 5a, 5b puissent être déplacés selon l'axe XX.

La charge hyperfréquence qui vient d'être décrite à l'aide de la figure 2 peut être réglée en valeur d'impédance; en effet par le déplacement des noyaux isolants 5a, 5b il est possible de réduire plus ou moins la quantité de liquide conducteur qui est contenue dans les tuyaux isolants 30, 31, et qui constitue à elle seule la partie résistive de la charge hyperfréquence; le liquide conducteur contenu dans les tuyaux métalliques 40, 11a, 21, 11b, 41, représente en effet des résistances qui sont court-circuitées par ces tuyaux métalliques. La valeur de la résistance des cylindres de liquide conducteur contenus dans les tuyaux isolants 30, 31 est ainsi réglable, pour une température donnée, d'une valeur minimale, qui est obtenue lorsque les noyaux 5a, 5b sont respectivement tout entiers introduits dans les tuyaux conducteurs 40, 21, à une valeur maximale, qui est obtenu lorsque les noyaux 5a, 5b sont respectivement tout entiers introduits dans les tuyaux isolants 30, 31; il est ainsi possible de maintenir cette résistance à une valeur constant quelle que soit la température du liquide, du moins dans les limites admissibles.

La charge selon la figure 2 mesure 2,30 m horstout dans sa plus grande dimension et a été étudiée pour fonctionner en antenne fictive de 800 kW, dans des bandes de fréquences situées aux alentours de 30 MHz.

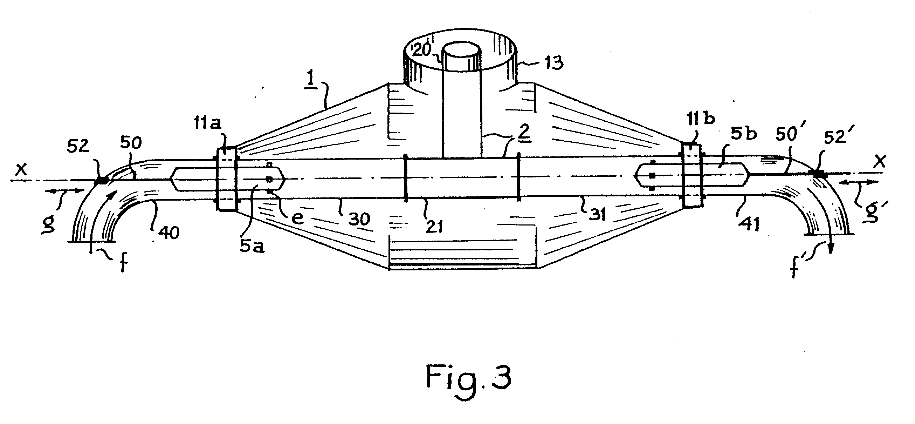

Une charge hyperfréquence analogue à la charge selon la figure 2 est représentée sur la figure 3. Cette charge ne se distingue de la charge précédente qu'en ce qui concerne la forme coudée du tuyau 41 qui est, ici, identique au tuyau coudé 40 et comporte aussi un joint d'étanchéité, 52', et en ce que concerne la façon dont les noyaux isolants 5a et 5b peuvent coulisser à l'intérieur du tube dans lequel circule le liquid conducteur. Le noyau 5a est toujours solidaire de la barre 50 qui permet de le déplacer selon l'axe XX (double flèche g) mais n'est plus solidaire du noyau 5b; en effet le moyau 5b est solidaire d'une barre 50' qui traverse le joint d'étanchéite 52' permettant le réglage, par translation (double flèche g'), de la position du noyau 5b dans le tube où circule le liquide conducteur. Le dispositif mécanique de réglage, non représenté, qui commandait, dans l'exemple décrit, le déplacement des noyaux 5a, 5b (figure 3), assurait un déplacement symétrique de ces noyaux; c'est-à-dire que le noyau 5a pouvait se déplacer entre une première position où il était tout entier contenu dans les tuyaux 40 et 11a et une seconde position où il était tout entier contenu dans le tuyau isolant 30 pendant que, à la même vitesse, le noyau 5b pouvait se déplacer entre une première position où il était tout entier contenu dans les tuyaux 41 et 11b et une seconde position où il était tout entier contenu dans le tuyau isolant 31. La première position des noyaux correspond à la valeur minimale de la résistance du contenu des tuyaux isolants 30 et 31 et donc de la charge hyperfréquence; la seconde position correspond à la valeur minimale.

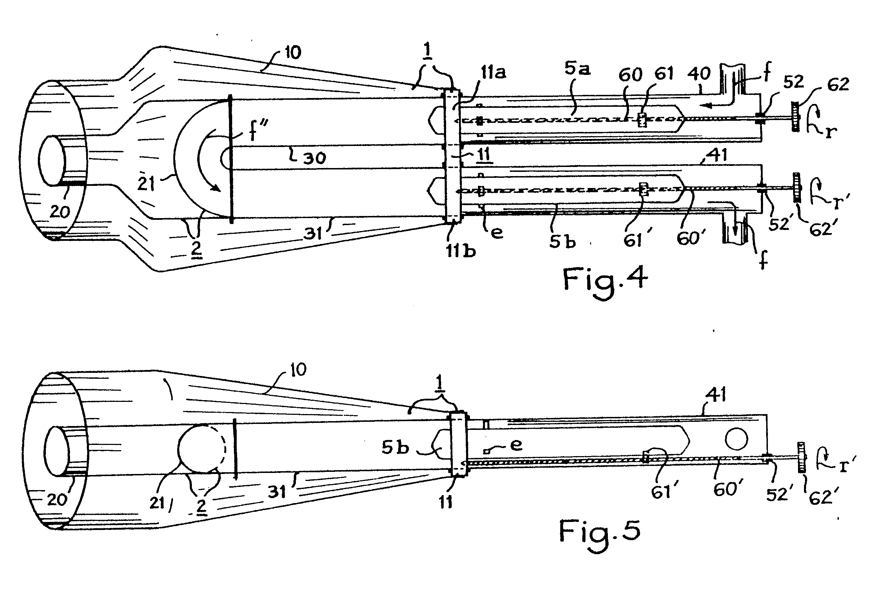

Les figures 4 et 5 sont respectivement une vue de dessus et une vue de côté d'une même charge selon l'invention. Cette charge correspond sensiblement aux charges selon les figures 2 et 3 mais dans lesquelles le tube où circule le liquide conducteur (40—11a—30—21—31—11b—41, figures 2 et 3) aurait été replié en son milieu (21) pour former un U de section uniforme. Cette structure est particulièrement favorable car déjà le fait de replier le tube amène un gain de place, c'est-à-dire une charge moins volumineuse à caractéristiques équivalentes; de plus, dans les figures 2 et 3, les parties de la charge comportant les cylindres de liquide conducteur (contenus dans les tuyaux 30 et 31) devaient chacune présenter une impédance caractéristique de 100 ohms, puisqu'elles venaient se raccorder sur un circuit d'entrée (éléments 13 et 20) d'impédance caractéristique choisie égale à 50 ohms; par contre dans la réalistion selon les figures 4 et 5 c'est la même partie de l'enveloppe extérieure 1 de la charge hyperfréquence qui entoure les cylindres de liquide conducteur (contenus dans les tuyaux 30 et 31), il en résulte que, pour une impédance caractéristique du circuit d'entrée de la charge hyperfrequence égale à 50 ohms, l'impédance caractéristique de la partie contenant les cylindres de liquide conducteur placés en parallèle sous une enveloppe extérieure commune, ne doit plus être que de 50 ohms; d'où, là encore un gain de place.

Les figures 4 et 5 montrent le tube en U dans lequel circule le liquide conducteur. La base du U est formé par un tuyau coudé, en cuivre, 21, dans lequel le sens d'écoulement du liquide (flèche f'') tourne de 180°. A partir du tuyau 21, le U est formé, pour chacune de ses branches, d'un tuyau isolant, 30, 31, d'une moitié d'une pièce conductrice, 11, dont les deux moitiés correpondant à l'assemblage côte à côte des bagues 11a, 11b des figures 2 et 3, et d'un tuyau conducteur, 40, 41, fermé partiellement à son extrémité opposée à la pièce conductrice, la seule ouverture à cette extrémité étant assurée par un joint d'étanchéité, 52, 52'; et l'arrivée (flèche f) de liquide conducteur dans le U est assurée par un conduit latéral débouchant dans le tuyau 40, tandis que le départ (flèche f) se fait par un autre conduit latéral débouchant dans le tuyau 41. L'assemblage des tuyaux composant le U où circule le liquide conducteur, se fait par brides de raccordement.

L'enveloppe, 1, de la charge hyperfréquence selon les figures 4 et 5, comporte une sorte de jupe en aluminium, 10, soudée, sur la pièce conductrice 11 à l'une de ses extrémités et que va en s'évasant jusqu'au delà du tuyau coudé 21 pour, ensuite, se rétrécir et former le conducteur exterior du câble coaxial qui constitue l'accès de la charge. Le conducteur intérieur du câble coaxial d'accès est constitué par un élément métallique creux, 20, dont la forme cylindrique est modifiée au voisinage de la base du circuit hydraulique en U; l'élément creux 20 forme, avec le tuyau coudé 21 auquel il est soudé, une pièce métallique unique 2.

Dans les deux branches du circuit hydraulique en U des figures 4 et 5, sont disposés respectivement deux noyaux isolants 5a, 5b, de forme allongée, munis au voisinage d'une de leurs extrémités d'ergots de guidage, isolants, tels que e, disposés à 120° les uns des autres. Ces noyaux peuvent être déplacés par translation dans le sens de la grande dimension des branches du U, grâce à un ensemble mécanique dont la partie propre à la charge est formée d'une vis métallique "sans fin" 60, 60', associé à un écrou formé d'une plaquette métallique 61, 61', solidaire du noyau et percée d'un trou fileté traversé par la vis métallique 60, 60' correspondante. Les vis "sans fin" sont disposées partiellement dans les tuyaux isolants 40, 41 dont elles ressortent par les joints d'étanchéité 52, 52'; les vis 60, 60' ne sont filetées que sur une portion de leur longueur située à l'intérieur des tubes isolants 40, 41; leur extrémité extérieure au tube isolant comporte une roue dentée, 62, 62', tandis que leur autre extémité vient en butée dans une cuvette creusée dans la pièce conductrice 11.

Les roues dentées 62, 62' sont acouplées à un moteur, non représenté, par une chaîne, également non représentée. Le moteur entraîne donc les vis 60, 60' dans un mouvement de rotation sur elles-mêmes (flèches r et r'); la rotation du moteur pouvant être commandée dans les deux sens cela permet de commander le sens du mouvement de translation qui en résulte pour les noyaux isolants 5a, 5b. Comme dans le cas des figures 2 et 3, il est ainsi possible de régler la valeur de la résistance présentée par les cylindres de liquide conducteur, contenus dans les tuyaux isolants 30 et 31: la valeur minimale est obtenu lorsque les noyaux sont dans les tuyaux 40, 41 et la valeur maximale quand les noyaux ont pénétré aux maximum dans les tuyaux isolants 30, 31.

Entre son accès coaxial et les roues dentées 62, 62', la charge selon les figures 4 et 5 a une longueur hors tout de 1,30 mètre; cette charge a été étudiée pour fonctionner commen antenne fictive de 800 kW dans des bandes de fréquences situées aux alentours de 30 MHz.

L'invention qui vient d'être décrite n'est pas limitée à l'exemple décrit, elle porte d'une façon plus générale sur l'utilisation d'un dispositif isolant placé dans le circuit hydraulique à liquide conducteur d'une charge hyperfréquence, et dont la position à l'intérieur de ce circuit peut être modifiée de manière à réduire plus ou moins le volume de liquide conducteur situé dans les zones du circuit hydraulique où ce liquide conducteur contribue à constituer l'impédance de la charge. Il est entendu par ailleurs que lorsqu'il est question de dispositif isolant il faut entendre d'une façon très générale un dispositif dont la conductivité est nettement inférieure à celle du liquide conducteur utilisé dans la charge.

Il est de plus à noter que les tuyaux 40, 41 des figures 2 à 5, de même d'ailleurs que le tuyau 4 de la figure 1, peuvent aussi bien être des tuyaux conducteurs que des tuyaux isolants.

## Revendications

1. Charge hyperfréquence à liquide conducteur, pour générateur de grande puissance, comportant une première (1) et une seconde (2) pièce métallique conductrice, isolées électriquement l'une de l'autre et formant entre elles l'accès de la charge, et un circuit hydraulique formé de tuyaux (11a—30—21—31—11b) en communication entre eux et contenant un liquide conducteur, ces tuyaux comportant: des tuyaux conducteurs (11a, 11b, 21) qui, pour une première (11a, 11b)) et une deuxième (21) partie, sont en contact respectivement avec la première (1) et la second (2) pièce, et des tuyaux isolants (30, 31) situés en série entre les tuyaux de la première et de la deuxième partie, caractérisée par un dispositif isolant (5a, 5b) placé à l'intérieur du circuit hydraulique et par des moyens (50, 50', 52, 52', 62, 62') pour introduire, sur une longueur réglable, le dispositif isolant dans le tuyaux isolants.

2. Charge hyperfréquence selon la revendication 1, caractérisée en ce que les tuyaux de la première (11a, 11b) et de la deuxième (21) partie forment, avec les tuyaux isolants (30, 31), un tube continu, rectiligne, de section constant, comportant successivement un tuyau (11a) de la première partie, un des tuyaux isolants (30), un tuyau (21) de la deuxième partie, un autre des tuyaux isolants (31) et un autre tuyau (11b) de la première partie et en ce que le dispositif isolant comporte deux noyaux (5a, 5b) dont la longueur de pénétration dans, respectivement, l'un et l'autre des tuyaux isolants (30, 31) est réglable.

3. Charge hyperfréquence selon la revendication 2, caractérisée en ce que les moyens comportent: une première barre (50) disposée partiellement à l'intérieur du tube, selon la direction longitudinale de ce tube, et qui traverse la paroi du circuit hydraulique par un joint d'étanchéité (52) et une seconde barre (51) qui relie entre eux les deux noyaux.

4. Charge hyperfréquence selon la revendication 2, caractérisée en ce que les moyens comportent une première (50) et une seconde (50') barre, disposées partiellement à l'intérieur du tube (11a, 30, 21, 31, 11b), selon la direction longitudinale de ce tube, situées respectivement au voisinage des deux extrémités du tube, reliées chacun à l'un des noyaux, et qui traversent la paroi du circuit hydraulique par un joint d'étanchéité (52, 52').

5. Charge hyperfréquence selon la revendication 1, caractérisée en ce que les tuyaux de la première (1) et de la deuxième (21) partie forment, avec les tuyaux isolants (30, 31), un tube continu, un U, de section uniforme, comportant successivement un tuyau (11) de la première partie, un des tuyaux isolants (30), un tuyau (21) de la deuxième partie qui forme la base du U, un autre des tuyaux isolants (31) et un autre tuyau (11b) de la première partie et en ce que le dispositif isolant comporte deux noyaux (5a, 5b) dont la longueur de pénétration dans, respectivement, l'un et l'autre des tuyaux isolants (30, 31) est réglable.

6. Charge hyperfréquence selon la revendication 5, caractérisée en ce que les moyens comportent une première (60) et une seconde (60') vis "sans fin" disposées au moins partiellement dans le circuit hydraulique, selon la direction longitudinale des deux branches du U et en ce que ces vis "sans fin" traversent respectivement deux écrous (61, 61'), ces écrous étant respectivement solidaires des deux noyaux (5a, 5b).

## Patentansprüche

1. Mikrowellen-Lastelement mit einer leitfähigen Flüssigkeit, für einen Hochleistungsgenerator, mit einem ersten (1) und einem zweiten (2) metallischen Leiterteil, wobei diese Leiterteile elektrisch voneinander isoliert sind und zwischen sich den Anschluß des Lastelements bilden, und einem Hydraulikkreis, der aus Rohrleitungen (11a—30—21—31—11b) gebildet ist, welche untereinander in Verbindung stehen und eine leitfähige Flüssigkeit enthalten, wobei diese Rohrleitungen umfassen: leitfähige Rohtleitungen (11a, 11b, 21), die an einem ersten (11a, 11b) bzw. einem zweiten (21) Teil in Kontakt mit dem ersten (1) bzw. zweiten (2) Teil stehen, und aus isolierenden Rohrleitungen (30, 31), die in Reihe zwischen den Rohrleitungen des ersten und des zweiten Teils liegen, gekennzeichnet durch eine Isoliervorrichtung (5a, 5b), die im Inneren des Hydraulikkreises angeordnet ist, und durch Mittel (50, 50', 52, 52', 62, 62'), um die Isoliervorrichtung über eine einstellbare Länge in die isolierenden Rohrleitungen einzuführen.

2. Mikrowellen-Lastelement nach Anspruch 1, dadurch gekennzeichnet, daß die Rohrleitungen des ersten (11a, 11b) und des zweiten (21) Teils mit den isolierenden Rohrleitungen (30, 31) ein durchgehendes, geradliniges Rohr von konstantem Querschnitt bilden, das nacheinander eine Rohrleitung (11a) des ersten Teils, eine der isolierenden Rohrleitungen (30), eine Rohrleitung (21) des zweiten Teils, eine weitere isolierende Rohrleitung (31) und eine weitere Rohrleitung (11b) des ersten Teils aufweist, und daß die Isoliervorrichtung zwei Kerne (5a, 5b) enthält, deren Eindringlänge in die eine bzw. andere isolierende Rohrleitung (30, 31) einstellbar ist.

3. Mikrowellen-Lastelement nach Anspruch 2, dadurch gekennzeichnet, daß die Mittel umfassen: eine erste Stange (50), die teilweise im Inneren des Rohres in dessen Längsrichtung angeordnet ist und die Wandung des Hydraulikkreises über eine Dichtung (52) durchquert, und eine zweite Stange (51), welche die zwei Kerne miteinander verbindet.

4. Mikrowellen-Lastelement nach Anspruch 2, dadurch gekennzeichnet, daß die Mittel eine erste (50) und eine zweite (50') Stange umfassen, die teilweise im Inneren des Rohres (11a, 30, 21, 31, 11b) in Längerichtung dieses Rohres angeordnet sind sowie jeweils in der Nähe eines der beiden Enden des Rohres liegen und jeweils an einen der Kerne angeschlossen sind sowie die Wandung des Hydraulikkreises über eine Dichtung (52, 52') durchqueren.

5. Mikrowellen-Lastelement nach Anspruch 1, dadurch gekennzeichnet, daß die Rohrleitungen des ersten (1) und des zweiten (21) Teils mit den isolierenden Rohrleitungen (30, 31) ein durchgehendes, U-förmiges Rohr von gleichbleibendem Querschnitt bilden, das nacheinander eine Rohrleitung (11a) des ersten Teils, isolierende Rohrleitungen (30), eine Rohrleitung (21) des zweiten Teils, welche die Basis des U bildet, eine weiter isolierende Rohrleitung (31) und eine weitere Rohrleitung (11b) des ersten Teiles umfaßt, und daß die Isoliervorrichtung zwei Kerne (5a, 5b) umfaßt, deren Eindringlänge in die eine bzw. andere isolierende Rohrleitung (30, 31) einstellbar ist.

6. Mikrowellen-Lastelement nach Anspruch 5, dadurch gekennzeichnet, daß die Mittel eine erste (60) und eine zweite (60') "Endlosschnecke" umfassen, wobei beide Endlosschnecken wenigstens teilweise in dem Hydraulikkreis in Längsrichtung der beiden Zweige des U angeordnet sind, und daß diese "Endlosschnecken" jeweils durch eine von zwei Schraubmuttern (61, 61') hindurchgehen, wobei diese Schraubmuttern jeweils fest mit einem der beiden Kerne (5a, 5b) verbunden sind.

**Claims**

1. Hyperfrequency load with a conductive liquid, for a high power generator, comprising a first (1) and a second (2) metallic conductive member, the members being electrically insulated from each other and forming the terminal of the load therebetween, and a hyperfrequency circuit formed of tubes (11a—30—21—31—11b) communicating with each other and containing a conductive liquid, these tubes comprising: conductive tubes (11a, 11b, 21) a first portion (11a, 11b) and a second portion (21) of which contact the first (1) and the second (2) members, respectively, and insulating tubes (30, 31) in series between the tubes of the first and second portions, characterized by an insulating device (5a, 5b) located inside of the hydraulic circuit and by means (50, 50', 52, 52', 62, 62') for introducing the insulating device into the insulating tubes across an adjustable length.

2. Hyperfrequency load according to claim 1, characterized in that the tubes of the first (11a, 11b) and the second (21) portions form with the insulating tubes (30, 31) a continuous rectilinear tube of constant section comprising successively a tube (11a) of the first portion, one of the insulating tubes (30), a tube (21) of the second portion, a further one of the insulating tubes (31) and another tube (11b) of the first portion, and in that the insulating device comprises two cores (5a, 5b) the penetration length of which into a respective insulating tube (30, 31) is adjustable.

3. Hyperfrequency load according to claim 2, characterized in that the means comprise: a first rod (50) located partially inside of the tube in the longitudinal direction of this tube and crossing the wall of the hydraulic circuit through a seal (52), and a second rod (51) interconnecting the two cores.

4. Hyperfrequency load according to claim 2, characterized in that the means comprise a first (50) and a second (50') rod, these rods being partially located inside of the tube (11a, 30, 21, 31, 11b) in the longitudinal direction of this tube, in the neighborhood of the two respective ends of the tube, and each connected to one of the cores, and crossing the wall of the hydraulic circuit through a seal (52, 52').

5. Hyperfrequency load according to claim 1, characterized in that the tubes of the first (1) and of the second (21) portion form with the insulating tubes (30, 31) a continuous tube of U-shape and uniform section, successively comprising a tube (11a) of the first portion, one of the insulating tubes (30), a tube (21) of the second portion forming the base of the U, a further one of the insulating tubes (31) and another tube (11b) of the first portion and in that the insulating device comprises two cores (5a, 5b) the penetration length of which into a respective insulating tube (30, 31) is adjustable.

6. Hyperfrequency load according to claim 5, characterized in that the means comprise a first (60) and a second (60') "endless" worm at least partially arranged in the hydraulic circuit in the longitudinal direction of the two legs of the U, and in that these "endless" worms respectively cross two nuts (61, 61'), these nuts being respectively connected to the two cores (5a, 5b).

Fig.1

Fig.2

Fig.3

0 117 778

Fig.4

Fig.5

0 117 778